# EUROPÄISCHE PATENTSCHRIFT

(11) **EP 2 286 513 B1**
(45) Veröffentlichungstag und Bekanntmachung des Hinweises auf die Patenterteilung: **14.12.2011**
(21) Anmeldenummer: 09757444.6
(22) Anmeldetag: 28.05.2009
(51) Int. Cl.: H03K 17/96, B60R 21/015

(54) **DETEKTIONSSYSTEM ZUR ANNÄHERUNGSERKENNUNG**
DETECTION SYSTEM FOR APPROACH RECOGNITION
SYSTÈME DE DÉTECTION DESTINÉ À DÉTECTER UN RAPPROCHEMENT

(30) Priorität: 03.06.2008 DE 102008026488
(43) Veröffentlichungstag der Anmeldung: 23.02.2011
(73) Patentinhaber: Continental Automotive GmbH, 30165 Hannover (DE)
(72) Erfinder: GRUNDMANN, Holmer-Geert, 64832 Babenhausen (DE); MEIER-ARENDT, Guido, 63225 Langen (DE)
(86) Internationale Anmeldenummer: PCT/EP2009/056546
(87) Internationale Veröffentlichungsnummer: WO 2009/147062

(56) Entgegenhaltungen:
- WO-A1-98/50258
- WO-A2-00/38949
- DE-A1-102006 014 061

## Beschreibung

Die Erfindung betrifft ein Detektionssystem zur Annäherungserkennung einer Hand- oder Armbewegung in Richtung einer Anzeige- und Bedieneinheit, wobei die Detektion zweistufig erfolgt.

Im Fahrzeuginnenbereich werden immer häufiger Näherungs- und Berührungssensoren eingesetzt um die Interaktion zwischen einem Nutzer und beispielsweise einem Informations- und Assistenzsystem benutzerfreundlich zu optimieren. Dabei werden Gesten oder Annäherungen detektiert und analysiert. Dies geschieht durch Generierung einer physikalischen Messgröße und deren Umwandlung in ein elektrisches Signal. Über ein Steuergerät wird dann eine Aktion auslöst.

Zur Stützung eines Interaktionsverlaufs zwischen Nutzer und Informationssystem sind einige Systeme bekannt, die eine Annäherung an ein Display oder ein Bedienelement detektieren und/oder eine Differenzierung zwischen Fahrer und Beifahrer erlauben. In Abhängigkeit des Detektionsergebnisses erfolgt dann eine dem Kontext angepasste Änderung des Anzeige- und Bedienkonzeptes. Vorrichtungen zur Annäherungsdetektion sind in einigen Druckschriften aufgeführt wie z.B. in der WO 00/38 949.

Die Druckschrift WO 2007/006514 A1 offenbart eine Vorrichtung zur Annäherungsdetektion mit Sende- und Empfangseinheit. Die Vorrichtung arbeitet dabei optoelektronisch im Fahrzeugaußenbereich. Bei Annährung einer Person aus einer vorbestimmten, mittigen Richtung wird im Nahbereich des Fahrzeugs mittels eines Codegebers, welcher sich bei der Person befindet, ein Steuersignal ausgelöst.

Die Detektion in bekannten Vorrichtungen erfolgt in einem definierten Detektionsbereich, der sich im Nahbereich eines

Displays oder einer Bedieneinheit befindet. Es erfolgt durch die Nutzung kapazitiver Sensoren eine permanente Signaleinkopplung auf den Nutzer.

Die bekannten Vorrichtungen und Verfahren haben den Nachteil, dass der Nutzer eine Sendeeinheit oder einen Codegeber zum Beispiel in Form einer Chipkarte oder eine, beispielsweise in den Autoschlüssel integrierte Sendeeinheit bei sich tragen muss, um ein Steuersignal auszulösen. Des Weiteren ist durch eine permanente Signaleinkopplung auf den menschlichen Körper ein hoher Energieaufwand vonnöten. Durch die dauerhafte Signaleinkopplung, d.h. das Aussetzen des Nutzers von magnetischen und/oder elektrischen Feldern können Detektionseinrichtungen vom Nutzer als gesundheitsschädlich empfunden werden.

Der Erfindung liegt daher die Aufgabe zugrunde, ein Detektionssystem zur Annäherungserkennung zu schaffen, welches keine nutzerseitige Sendeeinheit benötigt, energiesparend arbeitet und die Signaleinkopplung auf den menschlichen Körper minimiert.

Diese Aufgabe wird erfindungsgemäß durch die kennzeichnenden Merkmale der unabhängigen Ansprüche in Verbindung mit den Merkmalen der Oberbegriffe gelöst.

Das beanspruchte Detektionssystem für Fahrzeuge zur Annäherungserkennung einer Hand- oder Armbewegung in Richtung einer Anzeige- und Bedieneinheit im Fahrzeuginnenraum weist eine zweistufige Detektion auf. Die erste Stufe umfasst eine Fernbereichsdetektion durch mindestens einen optischen oder akustischen Sensor, die zweite Stufe umfasst eine Nahbereichsdetektion durch Signalein- und -auskopplung mittels eines kapazitiven Sensors. Das System ist so ausgestaltet, dass beim Übergang einer Hand- oder Armbewegung in den Nahbereich die Fernbereichsdetektion selbsttätig die Nahbereichsdetektion auslöst.

Das Verfahren zur Bedienung eines Detektionssystems für Fahrzeuge, insbesondere für Fahrzeuginnenräume, zur Annäherungserkennung einer Hand- oder Armbewegung in Richtung einer Anzeige- und Bedieneinheit, wobei die Detektion zweistufig erfolgt, und wobei mit dem Beginn einer Hand- oder Armbewegung in Richtung der Anzeige- und Bedieneinheit die Fernbereichsdetektion beginnt und die Fernbereichsdetektion die Nahbereichsdetektion beim Übergang der Bewegung vom Fern- in den Nahbereich selbsttätig auslöst.

Durch die Unterteilung des Detektionsvorgangs in einen Nah- und einen Fernbereich wird ein energiesparendes Verfahren erreicht. Beim Eintritt eines Nutzers in den Fernbereich wird durch optische Sensoren, die in Bezug auf andere Sensoren besonders energiesparend arbeiten, die Annäherung erkannt, und erst beim Eintritt in den Nahbereich werden Steuerbefehle und System-Nutzer-Dialoge, die energieaufwändiger sind, ausgeführt. Verlässt ein Nutzer den Fernbereich wieder bevor er in den Nahbereich vorgedrungen ist, so wird kein Dialog anberaumt und das System bleibt in einem Modus, der geringen Energieaufwands bedarf.

Durch die in den Unteransprüchen angegebenen Maßnahmen sind vorteilhaft Weiterbildungen und Verbesserungen möglich.

Erfindungsgemäß können die Sensoren der ersten Detektionsstufe Reflektions-Infrarot-Lichtschranken oder Ultraschallsensoren sein. Dies hat den Vorteil, dass diese Sensoren durch die Verwendung kurzer Wellenlängen im Millimeterbereich und darunter für die relativ kurze Reichweite unter einem halben Meter im Fahrzeuginnenraum geeignet sind. Der Fernbereich kann einen Nutzer-Anzeige-Abstand von 10 cm bis zu einem halben Meter haben. Dabei ist insbesondere bei geringen Distanzen zu beachten, dass der verwendete Sensor immer noch schnell genug sein muss, um den Nahbereichssensor bei Eintritt in den Nahbereich zu schalten. Die genauen Entfernungseinheiten für den Nah- und Fernbereich sind abhängig vom Fahrzeugtyp und können dementsprechend eingestellt werden. Die Anordnung des Fernbereichssensors erfolgt bevorzugterweise am Dachhimmel, beispielsweise nahe der Leselampe oder des Rückspiegels oder im Bereich des Anzeige- und Bedienelements.

In einem bevorzugten Ausführungsbeispiel setzt die erste Stufe der Detektion, die Fernbereichsdetektion mit Beginn einer Arm- oder Handbewegung in Richtung der Anzeige- und Bedieneinheit ein. Erfindungsgemäß wird dadurch eine zweite Detektionsstufe aktiviert, welche über Signaleinkopplung auf den Arm oder die Hand die Bewegung im Nahbereich der Anzeige- und Bedieneinheit und die entsprechenden kapazitive Signalauskopplung detektiert. Der Nahbereichssensor ist als Näherungsschalter ausgebildet. Die Funktion des kapazitiven Näherungsschalters beruht auf der Änderung des elektrischen Feldes in der Umgebung vor seiner Sensorelektrode, beispielsweise verursacht durch das Eindringen eines Armes oder einer Hand in den Nahbereich des Anzeige- und Bedienelementes, welcher durch diesen Sensor abdeckt wird. Durch die Detektion werden Maßnahmen zur Anpassung des Anzeige- und Bedienkonzepts eingeleitet. Die Annäherung an das System löst einen Steuerbefehl aus. Beispiele hierfür können Änderungen der Erscheinungsform von Anzeige- und Bedienfläche, gezieltes Freischalten oder Sperren von Funktionen für Fahrer und/oder Beifahrer oder Zuordnungen von Funktionen zu Fahrer oder Beifahrer sein.

In einer bevorzugten Ausführung der vorliegenden Erfindung ist ein Codegeber zur Signalauslösung nicht vonnöten. Allein die Annäherung in den Nahbereich der Anzeige- und Bedieneinheit führt bereits zur Ausführung des Steuerbefehls.

Erfindungsgemäß kann die Anzeige- und Bedieneinheit als Touch-Screen ausgebildet und in der Mittelkonsole eines Fahrzeugs angeordnet sein.

Durch die erfindungsgemäße zweistufige Detektion entfällt insbesondere im Nahbereich eine permanente Signaleinkopplung auf den Nutzer.

Durch die erste Stufe der Annäherungserkennung wird eine nutzerspezifische Naherkennung aktiviert. Damit können frühzeitig nutzerspezifische Inhalte angezeigt werden. Durch die frühzeitige Erkennung des Bedieners lassen sich systembedingt Latenzzeiten auf Nutzereingaben verkürzen.

Das Detektionssystem zur Annäherungserkennung soll anhand von einigen Ausführungsbeispielen näher erläutert werden. Es zeigen:
- Fig. 1: erste Stufe einer Annäherungsdetektion (Fernbereichsdetektion),
- Fig. 2: zweite Stufe einer Annäherungsdetektion (Nahbereichsdetektion),
- Fig. 3: Verlauf einer zweistufigen Annäherungsdetektion.

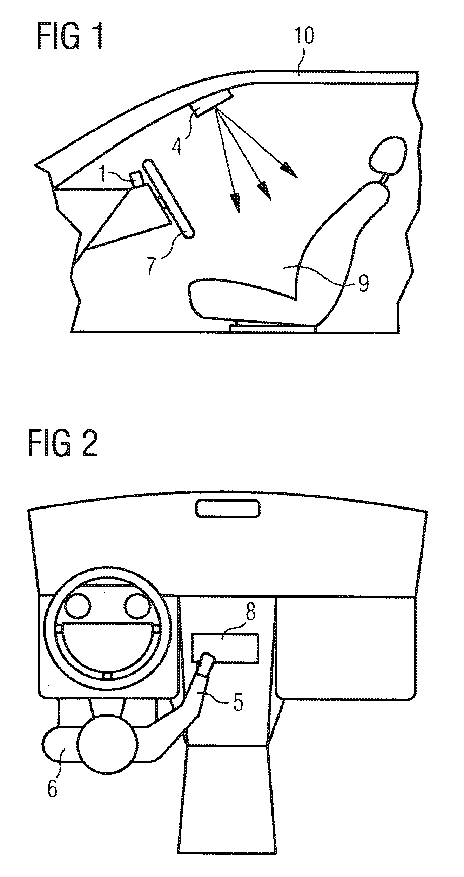

Fig. 1 zeigt die erste Stufe einer Annäherungsdetektion, die Fernbereichsdetektion in einem Fahrzeuginnenraum 9 durch mindestens einen optischen Sensor 4, ausgebildet als Reflektions-Infrarot-Lichtschranke. Die Anzeige- und Bedieneinheit 1 ist als Touch-Screen 7 oder als ein anderer Monitor ausgebildet und befindet sich in der Mittelkonsole 8 des Fahrzeugs. Die Reflektions-Lichtschranke befindet sich in Höhe des Rückspiegels an der Decke 10 des Fahrzeugs. Die erste Stufe der Detektion ist ebenfalls mit einem Ultraschallsensor möglich. Die Fernbereichsdetektion beginnt unmittelbar mit einer Hand- oder Armbewegung 5 in Richtung der Anzeige- und Bedieneinheit 1. Der Fernbereich ist im Fahrzeuginnenraum 9 zwischen wenigen Zentimetern und einem halben Meter einstellbar.

Beim Passieren der Lichtschranke wird das vom Nutzer reflektierte Lichtsignal vom Empfänger der Reflektionslichtschranke aufgenommen und in einer Auswerteeinheit dahingehend ausgewertet, ob sich die Näherungsbewegung in Richtung der Anzeige- und Bedieneinheit 1 fortsetzt, oder abgebrochen wird. Beim Verlassen des Fernbereiches in den Nahbereich, werden die Signalübertragungssensoren des Nahbereiches aktiviert. Durch eine geschickte Anordnung der Reflektionslichtschranke kann der Beginn der Bewegung registriert und die Detektion bereits in einem frühen Bewegungsstadium begonnen werden.

In Fig. 2 ist die zweite Stufe einer Annäherungsdetektion, die Nahbereichsdetektion gezeigt. Mittels Signaleinkopplung auf den menschlichen Körper 6 wird eine Detektion im Nahbereich der Anzeige- und Bedieneinheit 1 ausgeführt. Die Detektion erfolgt im Nahbereich über einen kapazitiven Abstandssensor. Dieser wandelt die zu überwachende Größe, hier die Entfernung, in ein weiterverarbeitendes Signal um. Die Funktion beruht auf der Änderung des elektrischen Feldes in der Umgebung der aktiven Zone, d.h. des Nahbereiches. Durch Annähern eines Armes oder einer Hand 5 in Richtung des Anzeige- und Bedienelementes 1 erfolgt im elektrischen Feld des Sensors eine Kapazitätsänderung. Durch diese wird ein Steuerbefehl an die Anzeige- und Bedieneinheit 1 abgegeben. Es erfolgt eine nutzerbestimmte Anpassung des Anzeige- und Bedienkonzepts, dass heißt, je nachdem, aus welcher Richtung das erste Signal auf den Empfänger trifft, schaltet das Anzeige- und Bediensystem 1 in der zweiten Detektionsstufe in den Fahrer- oder Beifahrermodus mit den entsprechenden Informationen.

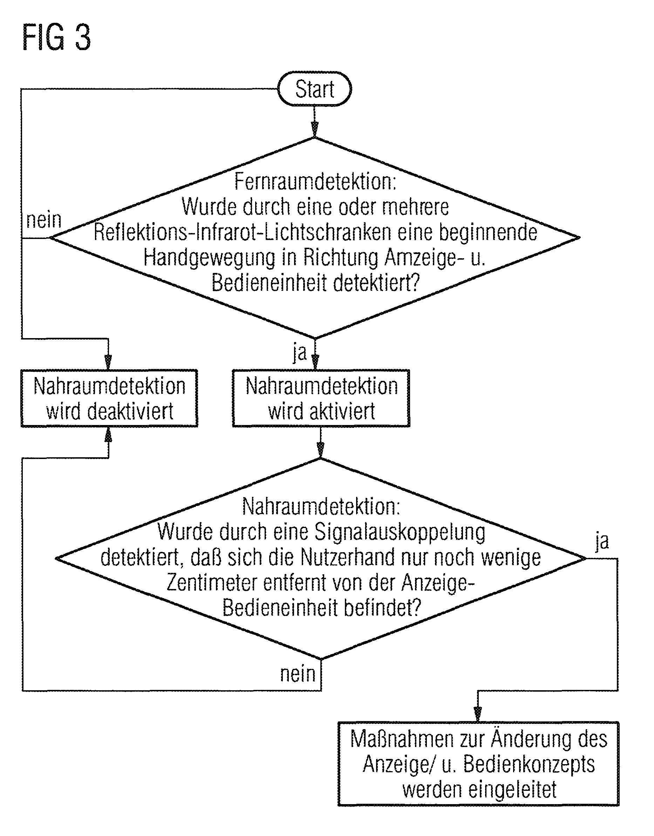

Der Verlauf einer zweistufigen Näherungdetektion ist in Fig. 3 gezeigt. Der Vorgang beginnt mit der Fernbereichsdetektion einer Handbewegung 5 in Richtung einer Anzeige- und Bedieneinheit 1 mittels Reflektions-Infrarot-Lichtschranken. Wird eine derartige Bewegung erkannt, wird bei Bewegungsfortführung in den Nahbereich die Nahbereichsdetektion aktiviert.

Wurde durch eine Signaleinkopplung die Hand 5 des Nutzers 6 wenige Zentimeter vor der Anzeige- und Bedieneinheit 1 detektiert, werden Maßnahmen zur Änderung des Anzeige- und Bedienkonzepts eingeleitet. Durch Zurückziehen der Nutzerhand 5 schlägt die Detektion fehl und die Nahbereichsdetektion wird deaktiviert. Die Fernbereichsdetektion setzt erneut ein.

## Patentansprüche

1. Detektionssystem für Fahrzeuge zur Annäherungserkennung einer Hand- oder Armbewegung (5) in Richtung einer Anzeige- und Bedieneinheit (1), wobei das System so ausgestaltet ist, dass eine zweistufige Detektion erfolgt und in Bezug auf die Anzeige- und Bedieneinheit ein Fernbereich in einem weiten Abstand und ein Nahbereich in einem Abstand unmittelbar vor der Anzeige- und Bedieneinheit existiert, **dadurch gekennzeichnet, dass** die Annäherungserkennung im Fahrzeuginnenraum (9) als erste Stufe eine Fernbereichsdetektion und als zweite Stufe eine Nahbereichsdetektion umfasst, wobei die Fernbereichsdetektion zur Erkennung der Annäherung mindestens einen optischen Sensor (4) oder mindestens einen akustischen Sensor (4) aufweist und die Fernbereichsdetektion so ausgestaltet ist, dass diese bei einem Übergang der Hand- oder Armbewegung (5) vom Fern- in den Nahbereich selbsttätig die Nahbereichsdetektion auslöst.

2. System nach Anspruch 1, **dadurch gekennzeichnet, dass** der mindestens eine optische Sensor (4) eine Reflexionsinfrarot-Lichtschranke ist.

3. System nach Anspruch 1, **dadurch gekennzeichnet, dass** der mindestens eine akustische Sensor (4) ein Ultraschallsensor ist.

4. System nach einem der vorgehenden Ansprüche, **da** - **durch gekennzeichnet**, dass der Fernbereich als Abstand zwischen Anzeige- und Bedieneinheit (1) und Nutzer (6) zwischen 1 und 50 cm ist.

5. System nach einem der vorgehenden Ansprüche, **da** - **durch gekennzeichnet**, dass die Anzeige- und Bedieneinheit einen Touch-Screen (7) aufweist.

6. System nach einem der vorgehenden Ansprüche, **da** - **durch gekennzeichnet**, dass die Anzeige- und Bedieneinheit (1) in der Mittelkonsole (8) eines Fahrzeugs integriert ist.

7. Verfahren zur Bedienung eines Detektionssystems für Fahrzeuge zur Annäherungserkennung einer Hand- oder Armbewegung (5) in Richtung einer Anzeige- und Bedieneinheit (1) im Fahrzeuginnenbereich, wobei durch das System eine zweistufige Detektion erfolgt, bei der eine Fernbereichsdetektion mindestens einen optischen Sensor (4) oder mindestens einen akustischen Sensor (4) aufweist und die Fernbereichsdetektion mit dem Beginn einer Hand- oder Armbewegung (5) in Richtung der Anzeige- und Bedieneinheit (1) beginnt und eine Nahbereichsdetektion durch eine direkte Annäherung der Hand- oder Armbewegung (5) an die Anzeige- und Bedieneinheit (1) durch die Fernbereichsdetektion selbsttätig ausgelöst wird.

8. Verfahren nach Anspruch 7, **dadurch gekennzeichnet, dass** durch die Annäherung an die Anzeige- und Bedieneinheit (1) im Nahbereich eine Änderung des Anzeige- und Bedienkonzeptes ausgelöst wird.

9. Verfahren nach Anspruch 7 oder 8, **dadurch gekennzeichnet, dass** die Anzeige- und Bedieneinheit (1) durch die Richtungserkennung der Annäherung an die Anzeige- und Bedieneinheit (1) durch die Fernbereichsdetektion nutzerspezifisch auf einen Fahrer oder einen Beifahrer einstellbar ist.

10. Verfahren nach einem der Ansprüche 7 bis 9, **da** - **durch gekennzeichnet**, dass die Fernbereichsdetektion mit dem unmittelbaren Beginn einer Hand- oder Armbewegung (5) eines Nutzers (6) in Richtung der Anzeige- und Bedieneinheit (1) beginnt.

11. Verfahren nach einem der Ansprüche 7 bis 10, **da** - **durch gekennzeichnet**, dass durch die Nahbereichsdetektion eine Anpassung des Anzeige- und Bedienkonzepts erfolgt.

12. Verfahren nach einem der Ansprüche 7 bis 11, **da** - **durch gekennzeichnet**, dass die Nahbereichsdetektion durch mindestens einen kapazitiven Sensor erfolgt.

13. Verfahren nach einem der Ansprüche 7 bis 12, **da** - **durch gekennzeichnet** dass die Nahbereichsdetektion durch kapazitive Einkopplung eines Signals erfolgt.

## Claims

1. Detection system for vehicles for recognizing the approach of a hand or arm movement (5) in the direction of a display and operating unit (1), the system being configured in such a manner that two-stage detection is carried out and, with respect to the display and operating unit, there is a long range at a great distance from the display and operating unit and a close range at a distance directly in front of the display and operating unit, **characterized in that** approach recognition in the vehicle interior (9) comprises long-range detection as a first stage and close-range detection as a second stage, long-range detection for recognizing the approach having at least one optical sensor (4) or at least one acoustic sensor (4), and long-range detection being configured in such a manner that it automatically triggers close-range detection when the hand or arm movement (5) changes from the long range to the close range.

2. System according to Claim 1, **characterized in that** the at least one optical sensor (4) is a reflection infrared light barrier.

3. System according to Claim 1, **characterized in that** the at least one acoustic sensor (4) is an ultrasonic sensor.

4. System according to one of the preceding claims, **characterized in that** the long range, as the distance between the display and operating unit (1) and the user (6), is between 1 and 50 cm.

5. System according to one of the preceding claims, **characterized in that** the display and operating unit has a touch screen (7).

6. System according to one of the preceding claims, **characterized in that** the display and operating unit (1) is integrated in the center console (8) of a vehicle.

7. Method for operating a detection system for vehicles for recognizing the approach of a hand or arm movement (5) in the direction of a display and operating unit (1) in the vehicle interior, the system carrying out two-stage detection in which long-range detection has at least one optical sensor (4) or at least one acoustic sensor (4) and long-range detection begins with the start of a hand or arm movement (5) in the direction of the display and operating unit (1) and long-range detection automatically triggers close-range detection as a result of the hand or arm movement (5) directly approaching the display and operating unit (1).

8. Method according to Claim 7, **characterized in that** a change in the display and operating concept is triggered as a result of the display and operating unit (1) being approached in the close range.

9. Method according to Claim 7 or 8, **characterized in that** the display and operating unit (1) can be set in a user-specific manner to a driver or a passenger by virtue of long-range detection recognizing the direction from which the display and operating unit (1) is approached.

10. Method according to one of Claims 7 to 9, **characterized in that** long-range detection begins with the immediate start of a hand or arm movement (5) of a user (6) in the direction of the display and operating unit (1).

11. Method according to one of Claims 7 to 10, **characterized in that** the display and operating concept is adapted as a result of close-range detection.

12. Method according to one of Claims 7 to 11, **characterized in that** close-range detection is carried out by at least one capacitive sensor.

13. Method according to one of Claims 7 to 12, **characterized in that** close-range detection is carried out by capacitively injecting a signal.

## Revendications

1. Système de détection de véhicules pour détecter un déplacement (5) de rapprochement d'une main ou d'un bras en direction d'une unité (1) d'affichage et de commande, le système étant tel qu'une détection s'effectue de deux stades et, rapporté à l'unité d'affichage et de commande, il existe une zone lointaine à une distance grande et une zone proche à une distance juste devant l'unité d'affichage et de commande, **caractérisé en ce que** la détection du rapprochement comprend dans l'espace (9) intérieur du véhicule, comme premier stade une détection en zone lointaine et, comme deuxième stade, une détection en zone proche, la détection en zone lointaine ayant pour la détection du rapprochement au moins un capteur (4) optique ou au moins un capteur (4) acoustique et la détection en zone lointaine étant telle que celle-ci déclenche automatiquement la détection en zone proche lors d'un passage du déplacement (5) de la main ou du bras de la zone lointaine à la zone proche.

2. Système suivant la revendication 1, **caractérisé en ce qu'**au moins un capteur (4) optique est une cellule photoélectrique à infrarouge par réflexion.

3. Système suivant la revendication 1, **caractérisé en ce que** le au moins un capteur (4) acoustique est un capteur par ultrason.

4. Système suivant l'une des revendications précédentes, **caractérisé en ce que** la zone lointaine, comme distance entre l'unité (1) d'affichage et de commande et l'utilisateur (6), est comprise entre 1 et 50 cm.

5. Système suivant l'une des revendications précédentes, **caractérisé en ce que** l'unité d'affichage et de commande comporte un écran (7) tactile.

6. Système suivant l'une des revendications précédentes, **caractérisé en ce que** l'unité (1) d'affichage et de commande est intégrée dans la console (8) médiane d'un véhicule.

7. Procédé de commande d'un système de détection pour des véhicules, en vue de détecter un mouvement (5) de rapprochement d'une main ou d'un bras en direction d'une unité (1) d'affichage et de commande dans la partie intérieure du véhicule, dans lequel on effectue par le système une détection en deux stades, dans laquelle une détection en zone lointaine comporte au moins un capteur (4) optique ou au moins un capteur (4) acoustique et la détection en zone lointaine commence avec le début d'un mouvement (5) de la main ou du bras en direction de l'unité (1) d'affichage et de commande et une détection en zone proche est déclenchée automatiquement par la détection en zone lointaine par le fait que le mouvement (5) de la main ou du bras se rapproche directement de l'unité (1) d'affichage et de commande.

8. Procédé suivant la revendication 7, **caractérisé en ce qu'**une modification du concept d'affichage et de commande dans la zone proche est déclenchée par le fait que l'on se rapproche de l'unité (1) d'affichage et de commande.

9. Procédé suivant la revendication 7 ou 8, **caractérisé en ce que** l'unité (1) d'affichage et de commande est réglable, d'une manière spécifique à l'utilisateur sur un conducteur ou sur un passager, par la détection de la direction du rapprochement vers l'unité (1) d'affichage et de commande par la détection en zone lointaine.

10. Procédé suivant l'une des revendications 7 à 9, **caractérisé en ce que** la détection en zone lointaine commence immédiatement avec le début d'un mouvement (5) de la main ou du bras d'un utilisateur en direction de l'unité (1) d'affichage et de commande.

11. Procédé suivant l'une des revendications 7 à 10, **caractérisé en ce qu'**une adaptation du concept d'affichage et de commande s'effectue par la détection en zone proche.

12. Procédé suivant l'une des revendications 7 à 11, **caractérisé en ce que** la détection en zone proche s'effectue par au moins un capteur capacitif.

13. Procédé suivant l'une des revendications 7 à 12, **caractérisé en ce que** la détection en zone proche s'effectue par couplage capacitif d'un signal.
